# EUROPEAN PATENT APPLICATION

(11) **EP 0 834 598 A1**
(43) Date of publication of application: **08.04.1998**
(21) Application number: 97115716.9
(22) Date of filing: 10.09.1997
(51) Int. Cl.: C23C 18/16

(54) **Selective metallization of three dimensional objects**

(30) Priority: 07.10.1996 US 726608
(71) Applicant: Shipley Company, L.L.C., Marlborough, Massachusetts 01752 (US)
(72) Inventor: Tabinor, Ivan T., Herefordshire HR8 IPG (GB); Hunter, Philip A., Tewkesbury, Glouester GL20 8BT (GB); Goosey, Martin T., Nr Daventry NN11 6LG (GB)
(74) Representative: Bunke, Holger, Dr.rer.nat. Dipl.-Chem.

(57) **Abstract**

A method for coating an irregularly shaped article with metal in a discrete pattern. The method uses double molding procedures where one molding covers a portion of another molding. A thermally decomposable organometallic complex of a metal catalytic to electroless metal deposition may be incorporated into the first or second molding or coated over the surface of either. The molding temperature decomposes the organometallic complex yielding a catalytic surface which may be metallized by immersion in an electroless metal plating solution.

## Description

### Introduction

This invention relates to selective metallization of three dimensional and other irregularly shaped objects. More particularly, this invention relates to a new process for selectively metallizing such objects in processes for the manufacture of diverse articles inclusive of electronic components.

### Background of the Invention

In recent years, the concept of using molded plastic substrates for the fabrication of three dimensional objects having metallized patterns such as circuit boards and interconnects has gained wide acceptance, in part due to the development of new high temperature thermoplastic base resins such as General Electric Company's Ultem® polyetherimide. For example, the use of three dimensional circuit boards provides enhanced design flexibility. Features such as standoffs, stiffeners, bosses, connectors and internal snaps to hold items such as batteries can be easily incorporated into the molded substrates. It has been found that enhanced design flexibility in the construction of the three dimensional substrate results in simplified assembly operations and installation of secondary component hardware. In addition, the majority of base resins used for such molded products provide electrical, mechanical or environmental properties superior to the properties of conventional laminates used in printed circuit board fabrication.

Applications based upon the three dimensional molded substrate are not limited to printed circuit board fabrication. For instance, injection molded three dimensional substrates have considerable application in the design of discrete components such as interconnects as well as electromechanical or electro-optical devices and housings for electronic components. Moreover, the ability of the three dimensional circuit board to eliminate stamped or formed metal contacts, wires and cables has wide market utility in all sorts of electrical devices or non-electronic products.

A drawback in the fabrication of three-dimensional metallized substrates involves the metallization process. The conventional process involves photoimaging of a desired pattern in a photoresist coating over the three dimensional substrate to define selected areas where metallization is to occur. For example, in a typical metallization process, a three dimensional molded substrate may have its entire surface catalyzed with a material catalytic to metal deposition such as a tin palladium electroless metal plating catalyst. Thereafter, a photoresist is coated onto the substrate and imaged in a desired pattern. Metallization will take place over areas where the photoresist coating has been removed by imaging and development. When a substrate is flat, exposure of the photoresist coating is easily accomplished using a contact photomask that defines a desired pattern. Because the photomask is in contact with the flat substrate, the photomask is easily aligned with the substrate and alignment is maintained during imaging using a vacuum frame. In this way, the image in the photomask is replicated in the resist coating. When the substrate is not flat, imaging problems are encountered making it difficult to replicate the photomask image in the photoresist coating. For example, deviations from a flat surface interfere with photomask placement. Small surface feature topography and imperfections disturb contact between the photomask and the substrate. A lack of intimate contact between the photomask and substrate results in diffusion of radiation passing through the photomask pattern into the photoresist coating. As a result, imaging failures occur resulting in narrower or wider than desired metal features formed on the molded substrate. Imaging of the three dimensional substrate is a problem that the industry has not satisfactorily resolved at this time other than by resort to procedures that are unduly expensive.

To avoid imaging problems, the industry has attempted to provide metallized circuit lines on three dimensional circuits using a process that avoids an imaging step. One approach has been the use of inks catalytic to metal deposition. For example, EPO Publication No. 0,132,677 discloses a low viscosity ink comprising a catalytic metal solution which is applied to the surface of a three dimensional part to be metallized by an ink-jet or ink-mist process. U.S. Patent Nos. 4,493,861 and 4,622,411 form a catalytic pattern by spraying a palladium containing alkyl resin through a template. The patterned resin is hardened for 5 hours and then electrolessly plated with nickel. U.S. Patent No. 4,622,411 further discloses silk screen printing of a palladium containing prepolymer which is cured for 8 hours prior to electroless deposition of nickel. In U.S. Patent No. 4,322,457, catalytic patterns are formed by printing a surfactant ink which is dried, treated with a sensitizing agent such as a tin salt, then catalyzed by treating with a palladium solution. In U.S. Patent No. 3,745,045, catalytic inks are based on an epoxy paint containing metal flakes such as of nickel or aluminum.

Spraying or misting of catalytic inks results in a diffuse pattern of the ink on the substrate. Screen printing of catalytic patterns requires the use of pastes having high viscosity due to a required high solids level and particulates. Because of their viscosity, such pastes typically have long drying times, often in excess of at least about one hour. For instance, in U.S. Patent No. 4,248,921, the paste comprises metal particles, metal salt and polymer. In U.S. Patent No. 4,469,714, the paste comprises a thermosetting or U.V. curable resin containing finely divided palladium catalyst. In U.S. Patent No. 4,832,989, the paste comprises a copolymer binder, palladium compounds and inorganic particulates such as aerosols of titanium dioxide, talc and the like. A typical paste dries in about one hour at 100°C. In British Patent specification No. 938,365, high viscosity (i.e. 200 poise) catalytic inks comprise phenolic resin, powdered metal such as aluminum and powdered silica. Canadian Patent No. 1,271,374 comprises pastes of a palladium compound and inorganic filler in a polyurethane solution. An illustrative paste dries in about 1 hour at 150°C. Japanese Kokai 59038370 discloses catalysts of fine metal powder in a polymeric binder while Japanese Kokai No. 62207878 discloses catalytic pastes containing a palladium hydrosol, a surfactant and a water soluble powder. Despite the variety of printing inks and techniques disclosed as useful for producing printed circuitry and other devices, a major deficiency in the use of pastes and screen printing methods is that three dimensional objects are difficult to screen and additionally, fine line image resolution is not achievable with such materials.

In U.S. Patent No. 5,168,264, a process for making molded circuits is disclosed which comprises double shot molding. In accordance with the process disclosed in this patent, a catalytic material is dispersed in a granular resin binder. This mixture is injected into a mold and the first layer of the three dimensional circuit is formed by a molding process. Thereafter, the granular resin free of catalytic material is injected into the mold in a pattern whereby areas of the first molded layer where metal deposition is undesired are covered with the resin and areas where metal deposition is desired remain bare of the resin. The second layer is then molded over the first layer. The so formed three dimensional substrate is then chemically roughened such as by contact with a chromic acid etchant to remove any thin films of resin overcoating the catalytic material. Metal may then be deposited electrolessly over the exposed catalytic material to form the desired circuit. Additional methods for making printed circuits and other metallized three dimensional articles by double shot molding are disclosed in Japanese Kokai 0087822 dated April 2, 1990, Japanese Kokai 0197076 dated March 17, 1992; Japanese Kokai 0197075 dated July 25, 1990; Japanese Kokai 0203985 dated July 18, 1991; Technology Trend of Molded Interconnection Devices, Kokusai, Kino Zairyo (1995), 15(3) 55-8; and Tomoyuki, New Molded Interconnection Devices, Plastics Fabrication and Uses, Shinsozai (1994), 5 (4), 56-9;

With modern day double shot molding equipment, three dimensional metallized substrates such as three dimensional circuits and interconnects may be manufactured inexpensively and rapidly with features of requisite dimension. However, the process of U.S. Patent No. 5,168,624 requires chemical roughening to uncover catalytic material overcoated with a thin film of resin during the molding process. The chemicals used are toxic and cannot be discharged to the environment without treatment. Moreover, the introduction of a chemical treatment step increases the complexity and cost of manufacturing circuits.

Each of the aforesaid references are incorporated herein by reference for their teaching of making three dimensional metallized articles and double shot molding procedures.

### Summary of the Invention

The subject invention is directed to metallization of discrete areas of an irregularly shaped surface of a three dimensional object. The invention utilizes molding procedures, preferably double shot molding procedures such as those procedures described in the several of the above cited references though other molding procedures are also suitable. The invention is based upon the utilization of a thermally decomposable catalyst composition which, during molding, decomposes and following molding, may be metallized without use of chemical treatment steps such as the chemical roughening step disclosed in U.S. Patent No. 5,168,624. The process of the invention may be used for the fabrication of diverse devices such as interconnects, three dimensional circuit boards, housings for electronic equipment metallized in a pattern to attenuate electromagnetic wave interference, etc.

In accordance with a preferred embodiment of the subject invention where the organometallic complex of a catalytic metal is contained in a molding resin, a three-dimensional surface suitable for metallization is formed using a double shot process and a composition that is any one of a mixture of a moldable resin admixed with the organometallic complex of a catalytic metal, a moldable resin substituted with an organometallic complex of a catalytic metal, or a mixture of the two. The moldable catalytic composition is delivered into the cavity of a mold and molded at a temperature that causes decomposition of the organometallic complex. Decomposition of the organometallic complex liberates catalytic metal that is believed to migrate at least to some extent to the top surfaces of the molded part to form a structure having a surface enriched in catalytic metal which may then be used to plate over the surfaces of the molded part, desirably in the absence of an additional chemical treatment step.

In accordance with the preferred embodiment of the invention, double-shot injection molding process is most preferred though other methods such as transfer and compression molding may also be utilized. Using the double shot method, a first molded part is formed by charging the resin to the mold. Thereafter, either the mold plates are replaced or retractable pins are moved and a second resin charge is fed into the cavity and the molding procedure completed at the requisite pressure and temperature. Either charge may contain the decomposable catalytic metal complex. The molding temperature is sufficient to decompose organometallic complex to provide the molded substrate capable of metallization in a desired discrete pattern.

Double shot injection molding procedures may be used for thermoplastic resins and in some cases, for thermoset resins. In this process, using thermoplastics for purposes of explanation, a first shot of a resin melt is charged to a mold followed by a second shot. Either may contain the organometallic catalytic material and either the first shot or the second shot can correspond to the image to be metallized. Though the procedure is used primarily for molding of thermoplastic materials, it is known that themosets may be injection molded under carefully controlled conditions. Transfer molding is used for thermoset resins and involves feeding softened pellets of a thermoset resin into a mold through a barrel under pressure. When the mold is filled with a first charge, the second softened charge is fed through the barrel. Again, either charge may be the organometallic catalytic material. Compression molding involves charging a mold with a resin powder, pressing the charge under heat and pressure to form the first molded article, replacing one or both of the molds, charging the second resin to the mold and repeating the molding procedure.

In accordance with an alternative lesser preferred embodiment of the invention, a three dimensional substrate may be coated with a liquid coating of the thermally decomposable organometallic complex of the catalytic metal and dried. A negative image of a desired circuit pattern is then molded over the substrate. In accordance with this procedure, areas of the surface of the substrate where metallization is desired remain uncoated with a resin layer and areas where metallization is undesired are masked by coating with resin as a consequence of the second molding operation. During the step of molding, the high molding temperature causes decomposition of the organometallic complex forming a catalytic layer over the substrate. Following molding, the part may be metallized using conventional electroless deposition techniques.

### Description of the Drawings

In the drawings:
Figure 1 is a cross-section of a one channel, two shot injection molding apparatus illustrating injection of a first shot into a mold;
Figure 2 is a cross-section of the one channel apparatus of Figure 1 illustrating injection of a second shot into the mold;
Figure 3 is a cross-section of a transfer molding apparatus illustrating charge of a first shot into a mold;
Figure 4 is a cross-section of the transfer molding apparatus of Figure 3 illustrating charge of a second shot into the mold;
Figures 5 to 8 comprise cross sections of an apparatus for compression molding of powders illustrating different steps in the process for use of the apparatus.
Figure 9 of the drawings represents a cross section of a molded article formed in accordance with the invention.
Figures 10 to 12 illustrate the use of the double shot molding procedure to form a complex part having circuitry integrated into the part.

### Description of the Preferred Embodiments

As described above, the invention contemplates use of an organometallic complex of a catalytic metal that thermally decomposes to yield a catalytic metal surface coating. The decomposition temperature of the organometallic should be lower than the molding temperature of the resin. Preferably, the decomposition temperature should range between about 40°C and 300°C and more preferably, between 100°C and 250°C.

The organometallic complex may be a substituent on the resin, an additive to a resin mixture or a mixture of an organometallic complex and a molding resin having organometallic substitution. As an additive, the organometallic complex may be coated onto a filler for the resin or coated onto glass miscrospheres and mixed with the molding resin. Organometallic complexes of metals catalytic to electroless metal deposition and capable of thermal decomposition below conventional molding temperatures are known in the art. One such material is disclosed in Belgian Patent No. 9400003 filed January 5, 1994 and incorporated herein by reference. In accordance with the invention disclosed in said application, there is provided a polymeric resin formed by admixture of a chloride or carboxylic complexing agent, a water soluble polymer containing hydroxyl and/or carboxyl groups, a basic compound and a solvent such as water, methanol or ethanol. The polymer is formed by separately mixing a palladium salt and a carboxylic or chloride complexing agent in a solvent until completely dissolved. A second solution of a polymer dissolved in a suitable solvent is formed. The solvent for both solutions is desirably water or a lower alcohol. The solutions are mixed and the pH adjusted to a value of between 1 to 10. At the time of mixing, other additives may be included in the formulation such as wetting agents, colorants, anti-foaming agents, adhesion promoters, surfactants, etc. The mixing of the two solutions results in complexation of the palladium salt onto the backbone of the polymeric resin. The palladium salt and the complexing agent are used in an amount of from about 0.05 to 5 percent by weight of the mixed solution and the polymer is used in an amount of from about 0.1 to 15 percent by weight of the mixed solution.

Preferred palladium salts for formation of the above polymer containing substituted organopalladium groups are palladium chloride, palladium sulfate, palladium nitrate and mixtures. Preferred complexing agents are carboxylic acids, o-hydroxy carboxylic acids, carboxylic polyacids and mixtures. Preferred chloride complexing agents are hydrochloric acid and chlorinated salts. The polymer may be a cellulosic polymer, an acrylic polymer and mixtures. Following formation of the complex of the palladium with the polymer, the polymer may be recovered from solution and ground to a fine powder or left in the solution and used as a liquid coating composition.

An additional resin substituted with an organometallic complex of a catalytic metal is disclosed in U.S. Patent No. 4,830,800 incorporated herein by reference. In accordance with this patent, the catalytic metal liberated by decomposition may be a member of the Group Ib and VIII metals of the Periodic Chart, particularly cobalt, nickel, palladium, copper and platinum. The ligand of the organometallic complex may be at least one ligand selected from the group consisting of tertiary phosphine, tertiary phosphite, carbon monoxide, a straight chain or cyclic olefin, a conjugated olefin, an aryl compound, an organic cyano compound, an organic isonitrile compound, a carbonyl compound, an organic mercapto compound, a heterocyclic compound, a compound having an alkyl group, a vinyl group, an allyl group, an aryl group, an ethylidyne group, an acyl group, an acyloxy group, an amino group, a halogen atom, an oxygen atom or a nitrogen atom. The polymer may be one soluble in organic solvents such as polystyrene, polyvinyl chloride, polysulfone, polycarbonate, polyacrylate, polyurethane, polyimide, a saturated or unsaturated polyester, an epoxy resin, a silicone resin, a diallyl phthalate resin, a cellulosic resin, a rosin modified maleic acid resin and copolymers thereof.

The organometallic complex of the polymer is formed by mixing the resin in an organic solvent and adding an organo metallic complex of the metal either as a separate solution or directly. The complex forms in situ during standing. The ratio of the polymer to the organometallic complex is desirably 100 parts by weight polymer to from 0.001 to 50 parts by weight as metal of the complex.

The polymer solution may have additives of the type described above. Once the solution is formed, if desired, the polymer may be recovered from solution and ground to a molding powder or the polymer solution may be coated over the surface of a molded part to form a coating of the organometallic complex over the part to be plated.

In accordance with the invention, the organometallic complex of the catalytic metal need not be substituted onto a polymer backbone. Suitable organometallic complexes are disclosed by Lomovsky and Boldyrev, *Journal of Materials Synthesis and Processing*, Vol. 2, No. 4, 1994 incorporated herein by reference. In accordance with this publication, metallization occurs by thermal decomposition of thermally sensitive copper salt such as copper hypophosphite to form a layer of a thermally sensitive copper compound on a dielectric surface by treating the surface with a solution of the complex and drying the coating at room or higher temperature. Thermal treatment of the surface yields decomposition products containing copper (II) as well as minute metallic copper particles.

A palladium complex is disclosed by Tieke, Zahir and Mathieu in *Advanced Materials*, 3 (1991) No. 2 incorporated herein by reference. This publication discloses complexes of zero valent palladium and dibenzylideneacetone. The complexes are disclosed by the author as suitable for formation of Langmuir - Blodgett films for use as hydrogenation catalysts though they are also suitable for use as plating catalysts in accordance with the subject invention.

The above described organometallic complexes may be admixed with a molding resin to form a molding powder that will thermally decompose during molding to yield a film catalytic to electroless metal deposition. Alternatively, they can be used as coating composition which would be coated over a substrate and dried to yield a surface layer of catalytic material. The coating composition is applied to a substrate using conventional coating methods such as spray coating, dipping, etc. dependent upon the shape of the substrate to be coated. If the three dimensional substrate is within a mold, spraying is desired.

The invention contemplates use of a molding operation to form a three dimensional object that is to have a portion of its surface metallized in a desired pattern. The pattern can be conductor lines in printed circuit fabrication, shielding for electronic devices to attenuate EMI emissions, pins, fixtures, heatsinks and connectors.

The preferred method of the invention involves double shot molding, also known as co-injection molding. Double shot or co-injection molding is a method known to the art and described in various publications such as by Eckardt, in *Popular Plastics*, May, 1989, pp.45 to 49 and by Digiantonic et al, in *Antec*, '92, 851 and by Donovan et al. in *Soc. Plast. Eng*., Tech. Paper (1975), 21, 608-13, each incorporated herein by reference. The double shot molding process requires a machine with independent injection units, each of which shoots a different material into a mold. The first material is injected through a primary runner system, as in a conventional injection molding cycle. During this injection, the mold volume to be occupied by the second material is shut off from the primary runner system. The mold is then opened and desirably, one of the two mold plates replaced with a second plate. The mold is again closed and the second runner system is connected to the volume to be filled. After sufficient cooling of the part, the mold is opened and the part is ejected. The injection of the first material through the primary runner system and the second material through the secondary runner system may occur simultaneously.

The process of double shot molding enables two dissimilar materials to be mechanically bonded. It is desirable that the first shot be prevented from totally solidifying before the second material is injected to prevent crack formation between the two due to differential shrinkage and to enhance adhesion between the two materials.

The double-shot process can also be accomplished with an indexing system whereby a round table rotates around a horizontal axis with a primary and secondary injection station. The first injection is accomplished at Station No. 1 and the second injection is accomplished at Station No. 2. Each station is run by an independent injection unit. This allows injection speeds and pressures to be controlled for each material utilized. A related procedure involves co-injection. The term co-injection molding is most typically used in connection with a process in which two or more different materials are laminated together by injection molding. The materials may be identical or may be different from each other. When different materials are used, they must be compatible in that they weld together and melt at approximately the same temperature. The co-injection method results in a sandwich configuration in which two or more thermoplastics are laminated together to take advantage of the different properties each contributes to the structure.

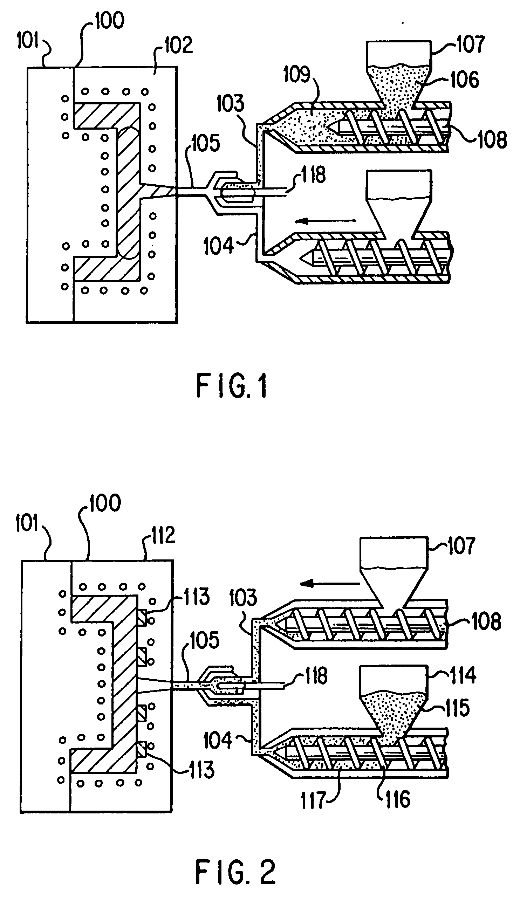

Figure 1 of the drawings illustrates a conventional 2 channel system. The apparatus comprises mold 100 having first and second plates 101 and 102. The mold has two injection ports, 103 and 104, which merge into a common entry port 105. The apparatus is used by feeding a first moldable resin 106 into the apparatus using hopper 107 which drops a first resin into heated screw conveyer 108. The screw conveyer 108 is typically hollow and has heating oil passed through it to heat the resin powder to a temperature sufficient to form a melt of the resin 109. The melt fills mold cavity 110 forming the first molded part 111. At this point, the mold may be opened and second mold plate 102 replaced with plate 112 having recesses 113 defining areas to be metallized following the molding process. The second shot is then fed to the apparatus using hopper 114 containing resin powders 115. The resin blend is passed to screw conveyer 116 where it is converted to melt 117 and fed to the mold to fill recesses 113 defining a discrete pattern. As an alternative to replacement of mold plate 102, the mold may be provided with retractable pins (not shown). Retractable pins are often used as a mold release mechanism whereby the pin is moved into the mold following the molding operation to remove the molded part from the mold. In the process contemplated, following the first molding, the retractable pins would be moved outward from the mold body defining recesses in the mold cavity. These recesses could be filled during the second molding step.

The above process can be reversed. Mold plate 101 may contain the recesses defining the desired discrete pattern. In addition, an apparatus can be used having a single feed port whereby a first resin would be fed to a hopper and molded. The first resin would then be removed from the hopper and replaced with a second resin and fed to the molding apparatus. Additionally, the apparatus of Figures 1 and 2 can be provided with an additional entry port shown in Figures 1 and 2 as entry port 118. This entry port can be used to inject a fluid into the mold following formation of the first molded part and prior to formation of the second molded part. The fluid may be an adhesive to bond the parts or a solution of the organometallic complex of the catalytic metal as will be described in greater detail below.

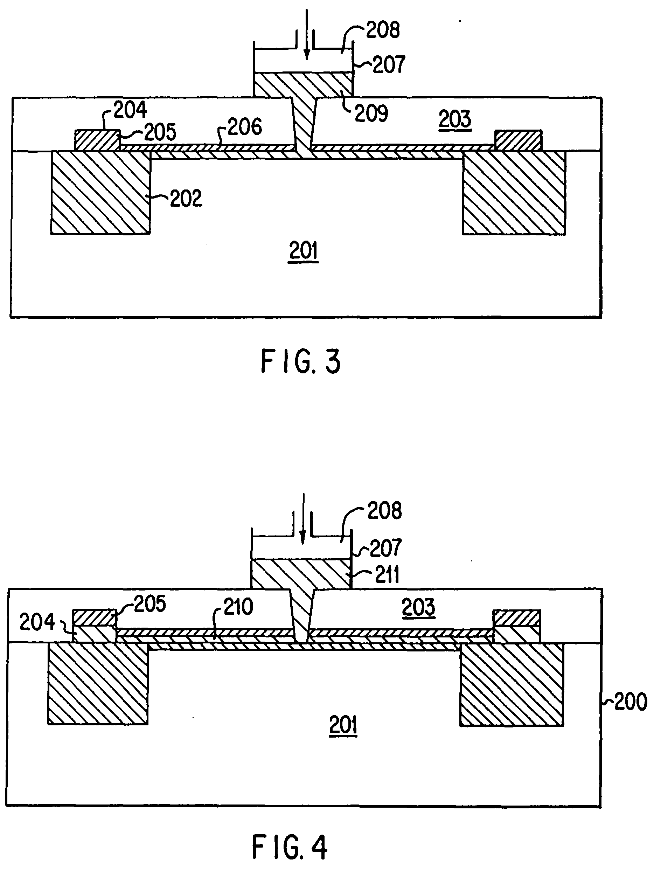

As illustrated in Figure 3 of the drawings, transfer molding is another method used for molding of irregularly shaped articles to be metallized in accordance with one embodiment of the invention. Transfer molding is typically used for thermoset resins. In the transfer molding process, a mold 200 is provided having a lower platen 201 defining cavity 202 and an upper platen 203 defining cavity 204. As illustrated, cavity 204 is filled with a retractable spacers 205 connected to retractable pins 206 to prevent filling of cavity 204 during feed of resin to cavity 202. The mold is provided with barrel 207 and plunger 208. Pelletized thermoset resin 209 is fed into the barrel 207 and is forced into to mold cavity 202 under pressure. The thermoset resin is fed prior to cure. The barrel is heated (by means not shown) to soften the resin, typically to a temperature that is slightly less than the melting point of the resin. The softened thermoset resin is forced into the mold cavity by pressure exerted by plunger 208. As the resin is pressed into the cavity in a softened state, it fills the mold cavity and cures. In the embodiment shown in Figure 3, upper platen 203 provided with cavity 204 containing retractable spacers and pins 205 and 206 respectively.

Figure 4 of the drawings illustrates molding of the second shot in the two shot molding process. As shown, retractable spacers 205 and pins 206 are withdrawn to define cavity 204 and feed line 210. In Figure 4, pellets 209 of the thermoset resin (Figure 3) have been pressed into a coherent molded structure within cavity 202. Retractable spacers 205 and pins 206 have been withdrawn leaving the feed line 206 and cavity 204 into which second resin 211 can be forced to form a second molding on the surface of molded part within cavity 202. Feed line 206 is used to feed resin from the barrel 207 into the cavity formed by retracting spacers 205.

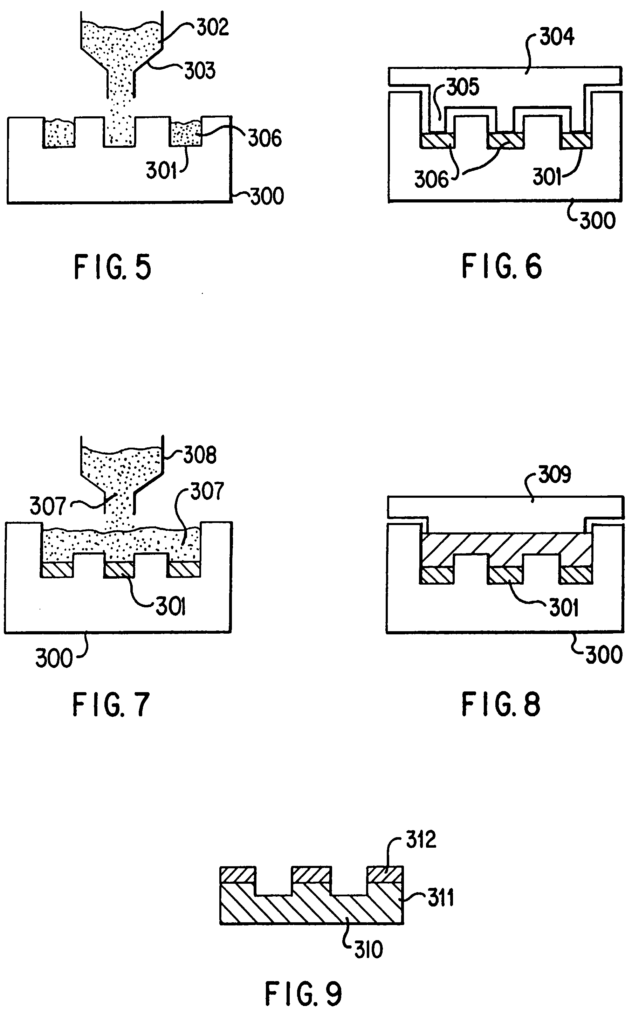

The above procedures force a resin melt into a mold. In accordance with an alternative embodiment of the invention, powders of the first and second resins may be used to form the molded part using compression or transfer molding procedures. This is embodiment of the invention is illustrated in Figures 5 through 8 of the drawings. With reference to Figure 5, there is shown a first plate of a mold 300 having recesses 301 defining a three dimensional pattern suitable for metallization. Resin powders 302 are fed into the mold plate 300 through hopper 302. Vibrator means may be used to compact the powders. A second mold plate 304 having protrusions 305 matching recesses 301 in the first mold plate is then placed over the first mold plate and the powders pressed under heat and pressure to form a first molded article 306. The second mold plate 304 is then removed and a second shot of resin powder 307 is added to mold 300 as shown in Figure 7 through hopper 308. As shown in Figure 8, the second mold plate is then replaced with mold plate 309 and the powders pressed using heat and pressure to form the molded article 310 illustrated in Figure 9 of the drawings having a substrate 311 of a first resin having projections 302 formed from a second resin.

There are two alternative embodiments for forming the three dimensional objects of the invention. In one embodiment, the organometallic complex of the catalytic metal is in the form of a molding resin and in the other embodiment, the complex is in the form of a liquid coating composition. When used in the form of a molding resin, the complex catalytic material may be substituted directly on the polymer backbone or the complex may be a separate additive to the resin composition. In addition, other thermoplastic resins free of the organometallic complex of the catalytic metal may be blended into the admixture such as styrene resins, acrylonitrile resins, polybutadiene resins, blends of styrene resins with other resins such as polyphenylene oxides, etc. When the organometallic complex of the catalytic material is in the form of a liquid, the complex is dissolved in a solvent for the complex in an amount sufficient to form a coating composition that may be sprayed or otherwise coated onto a molded article. Typically, the complex is contained in solution in an amount of from 1 to 20 percent by weight of the total coating composition. Regardless of how the complex of the catalytic metal is contained in the composition, its concentration expressed as catalytic metal should vary between about 0.1 and 10% by weight of the composition and preferably within a range of from about 0.2 to 2.5% by weight of the composition.

The description that follows illustrates several alternative embodiments of the invention utilizing equipment of the type described above. For purposes of illustration, the embodiments described below contemplate use of that polymer made by the procedures of Example 1 of Belgium Patent No. 9400003 referenced above, hereafter the "catalytic polymer". To utilize the catalytic polymer as a powder, following substitution of the organometallic onto the polymer backbone, it would be recovered from its solution such as by precipitation, dried and ground to a fine powder.

Embodiment 1 - A substrate resin such as polystyrene would be fed to a first mold plate. The polystyrene would be injected into the mold as a melt at a temperature of about 200°C. Following formation of the substrate, the mold would be cooled and opened and the second mold plate would be replaced with a different second mold plate, said latter mold plate having recesses defining areas to be metallized. The catalytic polymer would be mixed with polystyrene in an amount of 10 parts polystyrene to one part catalytic polymer and fed to the mold and molded to form projections conforming to the recesses in the mold on the molded substrate. These projections would be catalytic to electroless metal deposition as a consequence of the thermal decomposition of the organometallic complex during the molding operation. The part so formed would be immersed in an electroless plating solution to metallize the projections. Metallization would not occur over any other portion of the substrate.

Embodiment 2 - In this embodiment, the sequence of shots injected into the mold are reversed. The first shot would comprise the admixture of the catalytic polymer and the polystyrene. The second shot would comprise the polystyrene. The molded article would comprise a substrate material catalytic to electroless metal deposition coated with polystyrene in a discrete pattern inert to metal deposition. Electroless metal deposition would occur on the substrate material exposed to the electroless metal solution i.e., that portion of the substrate free of the polystyrene second molding.

Embodiment 3 - In this embodiment, the procedure of embodiment 2 would be repeated except that both shots would be free of catalytic polymer. Following the first shot and after opening the mold, the molded article would be sprayed with a solution of the catalytic polymer and the sprayed coating permitted to dry. Thereafter, the second molding would be formed over the first. The sprayed coating of the catalytic polymer would have decomposed to yield a catalytic surface. The molded article would then be immersed in an electroless plating solution. Electroless metal deposition would occur on the substrate material exposed to the electroless metal solution which would be that portion of the substrate free of the polystyrene second molding.

Any one of the above described embodiments can be repeated using a double shot compression or transfer molding procedures and molding powders as illustrated in the procedure of Figures 5 to 8 of the drawings.

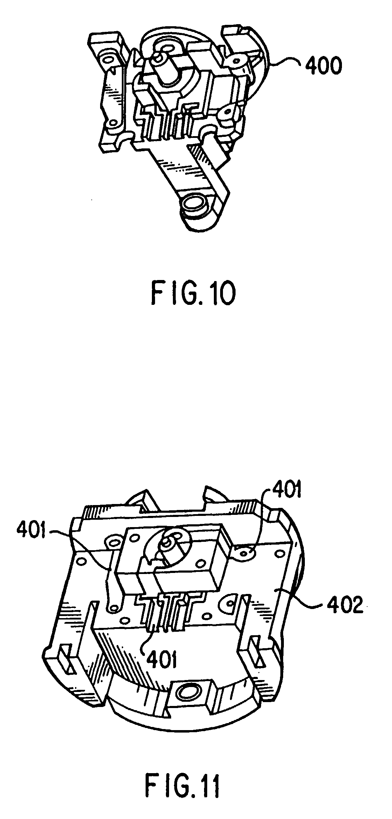

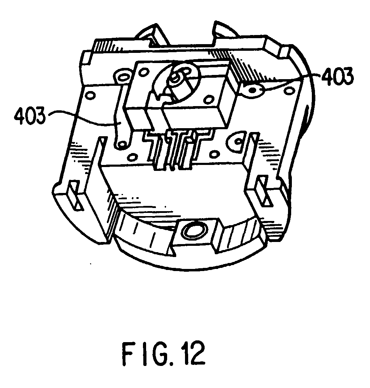

Figures 10 to 12 of the drawings illustrate the use of the double shot molding procedure to form a complex part having circuitry integrated into the part using procedures such as those of Embodiment 2 above. Figure 10 represents a molded complex three dimensional article 400 that has been molded of a thermoplastic material filled with catalytic polymer. The molding operation has resulted in thermal decomposition of the organometallic complex providing a surface 401 catalytically active to electroless metal deposition. A second shot is then injected into the mold to providing a second molding 402 encapsulating most of the first molded article 400. Portions of the catalytically active surface 401 of molded article 400 remain bare. The molded article may then be immersed in an electroless plating solution resulting in the metallization of the catalytically active surfaces to form metallized conductors 403.

## Claims

1. A method for depositing a discrete metal pattern on an article of manufacture having an irregular surface, said method comprising the steps of providing the thermal decomposition product of an organometallic complex of a catalytic metal on portions of said article where metal is to be deposited and immersing said article in an electroless plating solution for a time sufficient to deposit a metal coating of desired thickness.

2. The method of claim 1 where the thermal decomposition product of the catalytic metal is provided by providing a first molding resin containing the organometallic complex, molding a first molded article from said molding resin at a temperature which decomposes the organometallic complex to form a catalytic metal, providing a second molding resin free of the organometallic complex, molding a coating of the second molding resin over a portion of the first molded article, and plating electroless metal over surfaces of the first molded article that are not covered by the second molding resin.

3. The method of claim 2 where each of the first and second molding resins are thermoplastic.

4. The method of claim 2 where the organometallic complex is substituted onto the backbone of the first molding resin.

5. The method of claim 2 where the organometallic complex is substituted onto the backbone of a resin mixed with the first molding resin.

6. The method of claim 5 where the organometallic complex is substituted onto the backbone of a cellulosic resin.

7. The method of claim 2 where the organometallic complex is a compound mixed with the first molding resin.

8. The method of claim 2 where the metal of the organometallic complex is a complex of palladium.

9. The method of claim 1 where the thermal decomposition product of the catalytic metal is provided by providing a first molding resin free of an organometallic complex, molding a first molded article from said molding, providing a second molding resin containing the organometallic complex resin, molding a coating of the second molding resin over a portion of the first molded article resin at a temperature which decomposes the organometallic complex to form a catalytic metal, and plating electroless metal over surfaces of the second molding resin.

10. The method of claim 9 where each of the first and second molding resins are thermoplastic.

11. The method of claim 9 where the organometallic complex is substituted onto the backbone of the second molding resin.

12. The method of claim 9 where the organometallic complex is substituted onto the backbone of a resin mixed with the second molding resin.

13. The method of claim 12 where the organometallic complex is substituted onto the backbone of a cellulosic resin.

14. The method of claim 9 where the organometallic complex is a compound mixed with the second molding resin.

15. The method of claim 9 where the metal of the organometallic complex is palladium.

16. The method of claim 1 where the thermal decomposition product of the catalytic metal is provided by providing a first molding resin free of an organometallic complex, molding a first molded article from said molding resin, applying a liquid coating composition of an organometallic complex of a metal catalytic to electroless metal deposition to the surface of the first molded article, providing a second molding resin free of the organometallic complex, molding a coating of the second molding resin over a portion of the first molded article at a temperature which decomposes the organometallic complex to form a catalytic metal, and plating electroless metal over surfaces of the first molded article that are not covered by the second molding resin.

17. The method of claim 16 where each of the first and second molding resins are thermoplastic.

18. The method of claim 16 where the organometallic complex is substituted onto the backbone of a resin dissolved in a solvent.

19. The method of claim 18 where the organometallic complex is substituted onto the backbone of a cellulosic resin.

20. The method of claim 16 where the metal of the organometallic complex is a complex of palladium.
